# EUROPEAN PATENT SPECIFICATION

(11) **EP 0 653 716 B1**
(45) Date of publication and mention of the grant of the patent: **18.08.1999**
(21) Application number: 93402682.4
(22) Date of filing: 02.11.1993
(51) Int. Cl.: G06F 17/50

(54) **Method of verification of a finite state sequential machine**
Verfahren zur Prüfung eines sequentiellen endlichen Automaten
Procéde de vérification d'une machine séquentielle à états finis

(43) Date of publication of application: 17.05.1995
(73) Proprietor: BULL S.A., 78434 Louveciennes Cedex (FR)
(72) Inventor: Tamisier, Thomas, F-78100 Saint Germain en Laye (FR)
(74) Representative: Denis, Hervé

(56) References cited:
- WO-A-92/18944
- IEEE INTERNATIONAL CONFERENCE ON COMPUTER-AIDED DESIGN 11 November 1990 , SANTA CLARA US pages 126 - 129 COUDERT ET AL 'a unified framework for the formal verification of sequential circuits'
- PROCEEDINGS 29TH ACM/IEEE DESIGN AUTOMATION CONFERENCE 8 June 1992 , ANAHEIM CA US pages 614 - 619 CABODI ET AL 'a new model for improving symbolic product machine traversal'

## Description

The invention relates to a method of verification of a finite state sequential machine representing a technical system and more particularly to a method of computing by means of a computer an equivalence relation of a finite state machine.

The design of very large integration circuits requires zero-defect circuits because prototyping is very expensive to debug circuits. Hardware design and verification use an abstract description of a circuit realization (hardware device) and a circuit specification (expected behaviour) in the shape of a finite automaton, called finite state machine or FSM. The finite state machine is obtained from a description in an hardware description language (e. g., VHDL) of the circuit realization or the circuit specification by abstraction tools. The finite state machine performs the comparison by equivalence or implication of the circuit realization with the circuit specification. An example of a finite state machine is described in publication (1) : Workshop on Automating Verification Method for Finite State Systems, Grenoble, July 1989, "Verification of Synchronous Sequential Machines Based on Symbolic Execution", Coudert et al. In a finite state machine is used a method of computing equivalence relations, in particular the observable equivalence. A present application of observable equivalence in hardware design and verification is mainly the tool called Auto/Autograph as described for example in Proceedings of the DIMACS Workshop on Computer-Aided Verification, Vol. 3, DIMACS Series in Discrete Mathematics and Theoretical Computer Science, 1990, pages 477-492, Roy et al. "Auto/Autograph". This tool allows a reduction of complexity of reachable states from the initial states while minimizing the number of state variables, which results in hardware design in a reduction of the number of state registers in a circuit.

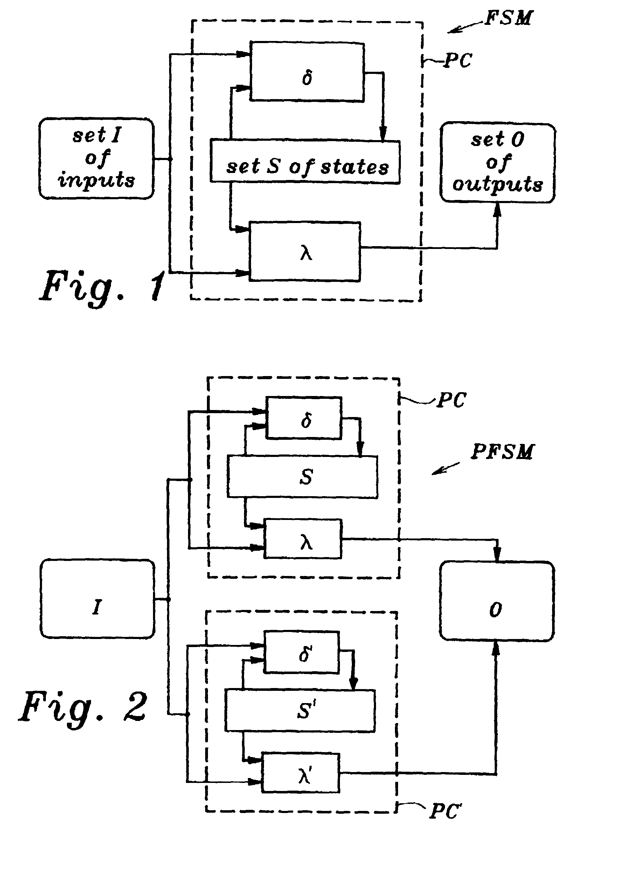

In Figure 1 is a block diagram illustrating the operation of a finite state machine FSM. It uses three sets and two functions. The three sets comprise a set of inputs. named I, a set of states, named S, and a set of outputs, named O, and the functions comprise a transition function δ of the type I x S → S and an output function λ of the type I x S → O. The three sets I, S and O are finite sets and made of inputs x. states s and outputs o, respectively. In the machine as illustrated in Figure 1, the transition function δ uses the set I of inputs as a first input and the set S of states as a second input to provide an output to the set S of states. The output faction λ uses the set I of inputs as a first input and the set S of states as a second input to provide a output to the set O of outputs. The transition faction δ, the output function λ and the set of states operate as a processing circuit PC. In operation, the machine FSM is initially in a predetermined state and input sequences from the set I of inputs are successively applied to the two factions. In response to each input sequence, the machine computes a state s from the input sequence, the current state and the transition faction δ while computing an output o from the input sequence, the current state ad the output faction λ and switching into the state s.

Also, it can be said that the machine FSM produces a sequence of n outputs in response to a sequence of n inputs. In the following example:
{s₁, s₂} ⊆ S and δ : (s₁, s₂) → s₂ and λ : (s₁, x₁) → o₂
{x₁, x₂} ⊆ I δ : (s₁, s₂) → s₁ λ : (s₂, x₁) → o₂
{o₁, o₂} ⊆ O
λ : (s₁, x₂) → o₁
then the machine FSM produces the sequence "o₂ o₂ o₁" from the sequence "x₁ x₁ x₂" when the state is s₁.

The invention relates to the problem of computation of the observable equivalence relation of a machine FSM. It will be assumed that the machine has the state s and produces a sequence of m outputs O = (o₁, ..., oₘ) in response to a sequence of m inputs X = (x₁, ..., xₘ). The observable equivalence is the equivalence for the states with regard to the produced outputs. Two states s and s' are said to be equivalent if, from states s and s', the machine always produces the same output sequence in response to the same input sequence of any length. Two states s and s' are said to be k-equivalent (where k is an integer ≥ 1) if they are equivalent for any sequence of a length ≤ k. The set of equivalent (respectively k-equivalent) state pairs is denoted E (respectively Eₖ). We assume that for any j ≤ i the set Eᵢ is included in Eⱼ. In other words, if ${\text{i<j : E⊆ E}}_{\text{j}} {\text{⊆ E}}_{\text{i}} \text{⊆ SxS}$ .

Furthermore, the invention is concerned with a data structure based on boolean factions. A boolean faction is of the type ${\text{f(x}}_{\text{1}} {\text{, ..., x}}_{\text{n}} {\text{) : {0, 1}}}^{\text{n}} \text{→ {0, 1}}$ . An identity is known between the boolean faction f and the set of variables ${\text{X ⊆ {0, 1}}}^{\text{n}} {\text{: X = {(x}}_{\text{1}} {\text{, ..., x}}_{\text{n}} {\text{) | f(x}}_{\text{1}} {\text{, ..., x}}_{\text{n}} \text{) = 1}}$ , so that every set can be represented by its characteristic function and both are denoted by the same symbol. Let ϕ be a boolean function and v₁,v₂, ..., vₙ its variable support. Also, let ${\text{ϕ[v}}_{\text{i}} \text{← 0]}$ be the formula in which the variable vᵢ is replaced by the constant 0 and O an order on v₁, v₂, ..., vₙ here considered as v₁ < v₂ < ... < vₙ. Then a graph currently named Shannon's tree of ϕ in the ordering O and denoted A(ϕ) can be built in compliance with the two following rules. First, the tree of constants are the leaves "true" and "false" and, second, the tree has a single root labelled by the variable v₁. From the root grow two branches, i. e. a branch aiming in the right direction on the tree of ${\text{ϕ [v}}_{\text{i}} \text{← 0]}$ and a branch aiming in the left direction on the tree of ${\text{ϕ[v}}_{\text{i}} \text{← 1]}$ . Two equivalent boolean factions have the same Shannon's tree modulo an ordering on the set of boolean variables and the choice of a variable support. From Shannon's tree A(ϕ) a boolean faction is commonly represented by Bryant's binary decision diagram currently named BDD of ϕ for the ordering O and described in publication (2) IEEE Transactions on Computers, C-35(8), August 1986, pages 677-691, R. E. Bryant: "Graph-Based Algorithms for Boolean Function Manipulation". In brief, as described in this publication, a BDD of ϕ for the ordering O is obtained from Shannon's tree by application until exhaustion of two reduction rules : (1) redundant node elimination and (2) equivalent subgraph share. The BDD is obtained regardless of the order of application of the two rules. As a result of redundant node elimination, the BDD has a stronger canonicity property than that of Shannon's trees since it does not refer to a variable support. Two equivalent factions for a predetermined ordering on the set of boolean variables have the same BDD. For example, ¬v₁ ∨ v₁ and ¬v₂ ∨ v₂ have the same BDD.

The transition faction is a vector ${\text{δ : {0, 1}}}^{\text{n}} {\text{→ {0, 1}}}^{\text{k}}$ . It is a vector of k boolean functions δ = (δ₁, ..., δₖ), with ${\text{δ}}_{\text{i}} {\text{: {0, 1}}}^{\text{n}} \text{→ {0, 1}}$ . In other words, ${\text{δ (x}}_{\text{1}} {\text{, ..., x}}_{\text{n}} {\text{) = [δ}}_{\text{1}} {\text{(x}}_{\text{1}} {\text{, ..., x}}_{\text{n}} {\text{), ..., δ}}_{\text{k}} {\text{(x}}_{\text{1}} {\text{, ..., x}}_{\text{n}} \text{)]}$ .

More generally, a completely specified finite state machine is a 5-tuple $\text{M = (I, O, S, δ, λ)}$ . The set ${\text{I = {0, 1}}}^{\text{k}}$ is the input space, the set ${\text{O = {0, 1}}}^{\text{ℓ}}$ is the output space and the set ${\text{S = {0, 1}}}^{\text{n}}$ is the state space. Each state variable sⱼ is associated with a boolean faction δj from S x I to {0, 1} and each output variable oⱼ is associated with a boolean function λⱼ from S x I to {0, 1}. The vector ${\text{δ = (δ}}_{\text{j}} \text{)}$ is the transition faction from S x I to S and the vector ${\text{λ = (λ}}_{\text{j}} \text{)}$ is the output function from S x I to O. The symbols s₁, ..., sₙ are used to denote the boolean state variables and x₁, ..., xₖ to denote the boolean input variables. The vector [s₁, ..., sₙ] is written s as well. In other words,
I = {0, 1}^{k} encoded on variables x₁, ..., xₖ
O = {0, 1}^{ℓ} encoded on variables o₁, ..., o_{ℓ}
S = {0, 1}ⁿ encoded on variables s₁, ..., sₙ${\text{δ (s}}_{\text{1}} {\text{, ..., s}}_{\text{n}} {\text{, x}}_{\text{1}} {\text{, ..., x}}_{\text{k}} {\text{) : {0, 1}}}^{\text{n+k}} {\text{→ {0, 1}}}^{\text{n}} {\text{= (δ}}_{\text{1}} {\text{, ..., δ}}_{\text{n}} \text{)}$ with${\text{δ}}_{\text{i}} {\text{(s}}_{\text{1}} {\text{, ..., s}}_{\text{n}} {\text{, x}}_{\text{1}} {\text{, ..., x}}_{\text{k}} {\text{) : {0, 1}}}^{\text{n+k}} \text{→ {0, 1}}$ ${\text{λ (s}}_{\text{1}} {\text{, ..., s}}_{\text{n}} {\text{, x}}_{\text{1}} {\text{, ..., x}}_{\text{k}} {\text{) : {0, 1}}}^{\text{n+k}} {\text{→ {0, 1}}}^{\text{ℓ}} {\text{= (λ}}_{\text{1}} {\text{, ...λ}}_{\text{ℓ}} \text{)}$ with${\text{λ}}_{\text{i}} {\text{(s}}_{\text{1}} {\text{, ..., s}}_{\text{n}} {\text{, x}}_{\text{1}} {\text{, ..., x}}_{\text{k}} {\text{) : {0, 1}}}^{\text{n+k}} \text{→ {0, 1}.}$

In Figure 2 is illustrated the structure of a product finite state machine referenced PFSM and here-under also named product machine. It is an intuitive and sequential object as that illustrated in Figure 1. The product machine is similar to that illustrated in Figure 1 in which processing circuit PC is duplicated to have a second processing circuit PC' connected parallel to first processing circuit PC between set I of inputs and set O of outputs. More specifically, the first processing circuit PC comprises a first transition function δ, a first output faction λ and a first set S of states s while the second processing circuit PC' comprises a second transition function δ', a second output function λ' and a second set S' of states s'. The first and second transition factions and the first and second output factions are connected to set I of inputs and respective sets S, S' of states while the outputs of first and second output factions are connected to set O of outputs.

Let s and s' be a pair of states, they are equivalent if the processing circuits having the respective states s and s' produce same outputs in response to same inputs. The product machine is used to determine whether a pair of states s and s' is made of equivalent states. The determination is made by concatenating the machine of Figure 1. Let S = {0, 1}ⁿ be encoded by the variables s₁, ..., sₙ. Let s'₁, ..., s'ₙ be n variables not used in the original machine. We denote the subset of pairs by BDD's on s₁, ..., sₙ, s'₁, ..., s'ₙ. For each boolean function δᵢ, the function δ'ᵢ is obtained by substituting the variables s'₁, ..., s'ₙ for the variables s₁, ..., sₙ, respectively. Similarly, for each boolean function λᵢ, the function λ'ᵢ is obtained by substituting the variables s'₁, ..., s'ₙ for the variables s₁, ..., sₙ, respectively. Then,${\text{δ'}}_{\text{i}} {\text{(s'}}_{\text{1}} {\text{, ..., s'}}_{\text{n}} {\text{, x}}_{\text{1}} {\text{, ..., x}}_{\text{k}} {\text{) = δ}}_{\text{i}} {\text{([s}}_{\text{1}} {\text{← s'}}_{\text{1}} {\text{], ..., [s}}_{\text{n}} {\text{← s'}}_{\text{n}} \text{])}$${\text{λ'}}_{\text{i}} {\text{(s'}}_{\text{1}} {\text{, ..., s'}}_{\text{n}} {\text{, x}}_{\text{1}} {\text{, ..., x}}_{\text{k}} {\text{) = λ}}_{\text{i}} {\text{([s}}_{\text{1}} {\text{← s'}}_{\text{1}} {\text{], ..., [s}}_{\text{n}} {\text{← s'}}_{\text{n}} \text{])}$

The transition function of the product machine is denoted ${\text{Δ = (δ}}_{\text{1}} {\text{, ..., δ}}_{\text{n}} {\text{, δ'}}_{\text{1}} {\text{, ..., δ'}}_{\text{n}} \text{)}$ and ${\text{Δ (s}}_{\text{1}} {\text{, ..., s}}_{\text{n}} {\text{, s'}}_{\text{1}} {\text{, ..., s'}}_{\text{n}} {\text{, x}}_{\text{1}} {\text{, ..., x}}_{\text{k}} {\text{) : {0, 1}}}^{\text{n+n+k}} {\text{→ {0, 1}}}^{\text{n+n}}$

The output function of the product machine is denoted ${\text{Λ = (λ}}_{\text{1}} {\text{, ..., λ}}_{\text{ℓ}} {\text{, λ'}}_{\text{1}} {\text{, ..., λ'}}_{\text{ℓ}} \text{)}$ and ${\text{Λ(s}}_{\text{1}} {\text{, ..., s}}_{\text{n}} {\text{, s'}}_{\text{1}} {\text{, ..., s'}}_{\text{n}} {\text{, x}}_{\text{1}} {\text{, ..., x}}_{\text{k}} {\text{) : {0, 1}}}^{\text{n+n+k}} {\text{→ {0, 1}}}^{\text{ℓ+ℓ}}$ .

Thus, the product machine is a 5-tuple $\text{M' = (I, [O x O], [S x S], Δ, Λ)}$ .

As other well known definitions, let δ be a boolean faction and x a variable, the following notations are used:$\text{∀xδ = δ(x ← 0) ∧ δ(x← 1)}$$\text{∃xδ = δ(x ← 0) ∨ δ(x ← 1)}$ in which x can be a vector of boolean variables.
Also, let δ be a boolean function ${\text{δ : {0, 1}}}^{\text{n}} {\text{→ {0, 1}}}^{\text{k}} {\text{and P ⊆ {0, 1}}}^{\text{k}}$ then the reverse image is ${\text{δ}}^{\text{-1}} {\text{(P) ⊆ {0, 1}}}^{\text{n}} {\text{= {(x}}_{\text{1}} {\text{, ..., x}}_{\text{n}} {\text{) | δ(x}}_{\text{1}} {\text{, ..., x}}_{\text{n}} \text{) ∈ P}}$

Once the product machine is constructed, each state in the product machine actually represents a pair of states s, s' for the machine. The goal is to compute the BDD on the variables s₁, ..., sₙ, s'₁, ..., s'ₙ, of the equivalent state pairs in which the first component is encoded on the variables s₁, ..., sₙ and the second component is encoded on the variables s'₁, ..., s'ₙ. In the prior art, an algorithm is used to get the equivalent state pairs. This algorithm consists in successively constructing the BDD's of the sets Eⱼ until the fixpoint is reached. The fixpoint of a function f is the element $\text{x : f(x) = x}$ . Here the fixpoint is reached when ${\text{E}}_{\text{n}} {\text{= E}}_{\text{n+1}} \text{= E}$ and is obtained by computing the Eⱼ suite as follows:${\text{E}}_{\text{1}} {\text{(s, s') = ∀x∧(λ}}_{\text{j}} {\text{(s, x) ⇔ λ'}}_{\text{j}} \text{(s', x)) j≤1}$${\text{E}}_{\text{n}} {\text{= E}}_{\text{1}} {\text{∧ (∀x(Δ}}^{\text{-1}} {\text{(E}}_{\text{n-1}} \text{))}$

This computation is based on a good variable ordering for the BDD's of the sets Eⱼ, which must be compatible with the relation corroborated by the experimentation :${\text{{s}}_{\text{1}} {\text{, s'}}_{\text{1}} {\text{} < {s}}_{\text{2}} {\text{, s'}}_{\text{2}} {\text{} < ... < {s}}_{\text{n}} {\text{, s'}}_{\text{n}} \text{}}$ Intuitively, such an ordering makes the most of the two following facts : the sets Eⱼ are graphs of equivalence relations and the original ordering of the sate space is s₁ < s₂ < ... < sₙ.

The computation of the set E₁ requires only boolean operations on BDD's, that are quadratic operations, and an elimination of variables. Experimental tests stipulate that the construction of set E₁ is generally performed at a low cost when the above variable ordering is chosen. To compute the set Eₙ from Eₙ₋₁, we have to calculate the reverse image of Eₙ₋₁ by vector Δ and to perform a universal elimination of the input variables. The reverse image computation can be performed using several methods. One involves the construction of the graph of the transition faction, but this graph cannot be built for very large machines FSM. Another method (called substitution method) consists in replacing each of variables s₁, s'₁, ..., sⱼ, s'ⱼ, ... by the corresponding δ₁, δ'₁, ..., δⱼ, δ'ⱼ, ... There exist some implementations that perform simultaneously this substitution and elimination of the input variables. An example of this prior method is described in the above-cited publication (1).

The computation of reverse image by the substitution method is made by an algorithm having an exponential complexity. Moreover, the vector Δ comprises 2n functions (δ, δ') and the reverse image is computed from the set Eₙ₋₁ having 2n boolean variables. Thus the computation of Δ⁻¹(Eₙ) is a long time consuming step and requires a large memory space.

Another known method of verification is described in IEEE International Conference on Computer-Aided Design, 11 November 1990, Santa Clara, US, pages 126-129, Coudert et al, "A Unified Framework for the Formal verification of sequential circuits". In this document, the idea is to compute a set of all the valid states of the machine by calculating an initial minimum set V₀ called Init and iteratively adding image elements Img (d, Vₖ x {0,1}ⁿ) to have the set Vₖ₊₁.

The present invention relates to a new method of computing Δ⁻¹(En), which corresponds to a new computation of the fixpoint reached when Eₙ = Eₙ₊₁ = E. It overcomes the drawbacks of the prior art in allowing computation in a short time using a substantially less large memory space.

More generally, the invention provides a method of verification of a finite state sequential machine as defined in claim 1.

The objects and advantages of the invention will become clearly apparent from the following description of a preferred embodiment of the invention referring to the appended drawings.
In the drawings :
Figure 1 is a block diagram of a finite state machine, and
Figure 2 is a block diagram of a product finite state machine.

The underlying idea of the present invention is based on the fact that the set Δ-¹(Eₙ) is the graph of an equivalence relation on S x S. To obtain set E₁, all the pairs of states having the same image by δ are to be found. To find them, the invention is directed to find from the set Eₙ₋₁ a vector θ having the following property :${\text{[θ(s) = θ(s')] ⇔ [(s, s') ∈ Δ}}^{\text{-1}} {\text{(E}}_{\text{n-1}} \text{)]}$ With the vector θ can be constructed Δ⁻¹(Eₙ) in the same manner as set E₁ is built from output function λ.

The present invention relates to a method of computing the reverse image of the transition function of a product finite state machine from the set of n-1 equivalent states, that is a method of computing Δ⁻¹(Eₙ₋₁), comprising the steps of:
(a) constructing in canonical way, from the BDD of the graph of the relation Eₙ₋₁, the BDD of the graph of a total function from S x S, named cross-section and denoted C(Eₙ₋₁), and
(b) constructing from the cross-section and the vector 6 a new vector denoted δⁿ⁻¹ = C(Eₙ₋₁) o δ. It will be shown that the new vector has the desired properties of the above vector θ. Thus this vector is obtained by a modification of the transition function δ with the help of the set C(Eₙ₋₁). Although the reverse image computation algorithm is used, the sets whose reverse image is now computed are subsets of S (encoded by the variables s₁, s₂, ..., sₙ) instead of the set Eₙ₋₁ of state pairs (encoded by the variables s₁, s₂, ..., sₙ, s'₁, s'₂, ..., s'ₙ) as in the prior method.

Then the method of the invention can comprise a third step (c) of computing the equivalent pairs of states with respect to the vector δⁿ⁻¹. These pairs are exactly the elements of (∀x(Δ⁻¹(Eₙ₋₁)). However, it is clear that the third step can be used to compute any existential or universal elimination of the variables in computing the reverse image by use of the method of the invention. In other words, instead of the step (c) used to compute the elements of (∀x(Δ⁻¹(Eₙ₋₁)) an alternative third step (c') can be used to compute the elements of (∃x(Δ⁻¹(Eₙ₋₁)).

The canonical cross-section C(Eₙ₋₁) defined in step (a) can be computed by using various methods. Here is presented a canonical way to obtain a graph of a function C(R) from a graph of a relation R. The function C(R) is called the cross-section of the relation R. The definition that will be given is a particular case of a method introduced in publication (3) Research Report, University of California, Berkeley, 1992, B. Lin and A. Richard Newton : "Implicit Manipulation of Equivalence Classes Using Binary Decision Diagrams", known under the name of compatible projection.

It will be assumed that all the elements of a set {0, 1}ⁿ are ordered by the increasing order of integers. For instance, the element (0, 0, ..., 1) represented by ( ¬s₁ ∧ ¬s₂ ∧ ... ∧¬sₙ₋₁ ∧ sₙ) is the predecessor of (0, 0 ..., 1, 0) represented by (¬ s₁ ∧ ¬s₂ ∧ ... ∧ sₙ₋₁ ∧ ¬sₙ).

Definition 1 : Let B and C be two sets and ϕ a relation from B into C and let ≤ be a total order on C, then the cross-section of ϕ is the partial function C(ϕ) defined as :$\text{C(ϕ): | B → C} \text{| x ↦ min({y|(x, y) ∈ ϕ})}$

To compute the cross-section of relation Eₙ₋₁, the variables of the codomain are s₁, ..., sₙ and the variables for the domain are s'₁, ..., s'ₙ. From the BDD of Eₙ₋₁ can be recursively constructed the BDD of C(Eₙ₋₁) applying the following transformation that remove from the BDD of Eₙ₋₁ the pairs that are not in C(Eₙ₋₁), which is the following algorithm 1.

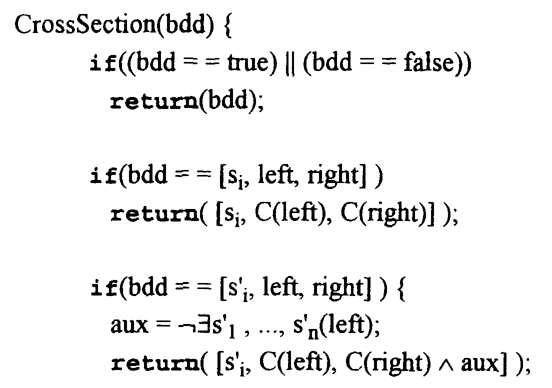

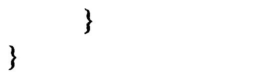

This construction can be performed by a unique traversal of the graph of Eₙ₋₁, provided intermediate results are stored in the graph nodes.

Then, according to the second step (b) of the method of the invention, the composition C(Eₙ₋₁) ∘ δ denoted δⁿ⁻¹ is to be constructed. The construction could be made by using different methods. The following example is a method proceeding by separately modifying each of the original function δⱼ of δ using the BDD of C(Eₙ₋₁).

The function δ is given as a vector of boolean functions (δ₁, ..., δₙ) and the δⱼ are on the state variables sᵢ and the input variables xᵢ. The vector ${\text{δ}}^{\text{n-1}} {\text{= δ}}_{\text{1}} {\text{}}^{\text{n-1}} {\text{, ..., δ}}_{\text{n}} {\text{}}^{\text{n-1}} \text{)}$ is built on the same variables, and we must have ${\text{δ}}^{\text{n-1}} {\text{(s, x) = C(E}}_{\text{n-1}} \text{) δ (s, x)}$ . Since Eₙ₋₁ is an equivalence relation, it is trivial to verify that C(Eₙ₋₁) is a function defined everywhere. Consequently, the composition δⁿ⁻¹ is defined everywhere, as δ is.

Let s be in S and Kᵢ (s) denote the value of the component sᵢ of s. For example, K₃( [0, 1, 1, ..., 0] ) is 1. The function δⱼⁿ⁻¹ can be defined by the following equation, for j = 1 to n:${\text{δ}}_{\text{1}} {\text{}}^{\text{n-1}} {\text{(s, x) = K}}_{\text{j}} {\text{[C(E}}_{\text{n-1}} \text{)(δ(s, x))]}$ Let us consider the BDD G of the graph of cross-section C(Eₙ₋₁). For j from 1 to n we construct the set${\text{D}}_{\text{j}} {\text{= (∃s'(¬(s}}_{\text{j}} {\text{⇔ s'}}_{\text{j}} \text{) ∧ G)}$ ${\text{D}}_{\text{j}} \text{⊆ S}$ includes all the states s such that ${\text{K}}_{\text{j}} {\text{(s) ≠ K}}_{\text{j}} \text{(G)}$ . The δⱼⁿ⁻¹ are obtained using the following theorem.

Theorem 1 : Let F be the vector C(Eₙ₋₁), then ${\text{F ∘ δ = δ}}^{\text{n-1}} {\text{= (δ}}_{\text{1}} {\text{}}^{\text{n-1}} {\text{, ..., δ}}_{\text{n}} {\text{}}^{\text{n-1}} \text{)}$ can be defined as${\text{δ}}_{\text{j}} {\text{}}^{\text{n-1}} {\text{.= ¬(δ}}_{\text{j}} {\text{⇔ δ}}^{\text{-1}} {\text{(D}}_{\text{j}} \text{))}$

As a proof, it is checked that ${\text{δ}}_{\text{j}} {\text{}}^{\text{n-1}} {\text{(s, x) = K}}_{\text{j}} \text{[F(δ(s, x))]}$ by cases, depending on the values of Kⱼ (δ(s, x)) and Kⱼ [F(δ(s, x))] :
Kⱼ (δ(s, x)) = 0 and Kⱼ [F(δ(s, x))] = 0.
   Since δ(s, x) is not in Dⱼ and (s, x) is not in δ⁻¹ (Dⱼ) and since (s, x) is not in δ, δⱼⁿ⁻¹(s, x) = 0.
Kⱼ (δ(s, x)) = 0 and Kⱼ [F(δ(s, x))] = 1.
   Since δ(s, x) is in Dⱼ and (s, x) is not in δ⁻¹ (Dⱼ) and since δ (s, x) = 0 we have δⱼⁿ⁻1(s, x) = 1.
Kⱼ (δ(s, x)) = 1 and Kⱼ [F(δ(s, x))] = 0.
   Since δ(s, x) is in Dⱼ and (s, x) is in δ⁻¹(Dⱼ) and since (s, x) is in δ (s, x) = 0, δⱼⁿ⁻¹(s, x) = 0.
Kⱼ (δ(s, x)) = 1 and Kⱼ [F(δ(s, x))] = 1.
Since δ(s, x) is not in Dⱼ and (s, x) is not in δ⁻¹ (Dⱼ) and since (s, x) is in δ, δⱼⁿ⁻¹⁽s, x) = 0.

The correctness of the composition will now be shown. It must be checked that the following equation holds:${\text{[(s, s') ∈ ∀x(Δ}}^{\text{-1}} {\text{(E}}_{\text{n-1}} {\text{))] ⇔ ∀x(δ}}^{\text{n-1}} {\text{(s) = δ}}^{\text{n-1}} \text{(s'))}$

Proposition 1 : If ϕ is a transitive and symmetrical relation from B into B defined anywhere, then$\text{∀x, y(( C(ϕ)(x) = C(ϕ)(y)) ⇔ ((x, y) ∈ ϕ))}$ Proof:
⇒ Let $\text{t = C(ϕ)(x)}$ . By definition, two pairs (x, t) and (y, t) are in ϕ. By symmetry, (t, y) is in ϕ. Thus, by transitivity, (x, y) is in ϕ.
⇐ Suppose that $\text{C(ϕ)(x) < C(ϕ)(y)}$ and that $\text{(x, y) ∈ ϕ}$ . By symmetry, (x, y) is in ϕ. By transitivity, (yC(ϕ)(x)) is in ϕ. Now, $\text{(yC(ϕ)(x)) ∈ ϕ}$ is inconsistent with the assumption $\text{C(ϕ)(y) < C(ϕ)(x)}$ .

Theorem 2 : The composition C(Eₙ₋₁) ∘ δ verifies the property of the equation to be shown,.

The statement results from Proposition 1.
∀x ∈ I [F(δ(s, x)) = F(δ(s', x))]
⇔ ∀x ∈ I [(δ(s, x), δ(s', x)) ∈ En₋₁] from Proposition 1
⇔ ∀x ∈ I [(δ(s, s', x)) ∈ En₋₁] from definition of δ
⇔ (s, s') ∈ (∀x(Δ⁻¹(En₋₁)) from a ∀-elimination of input variables

Thus, a new algorithm allows to compute the set Eₙ from Eₙ₋₁. The BDD is the graph of an equivalence relation on S x S. The set Eₙ₋₁ is built on boolean variables s₁, s₂, ..., sₙ, s'₁, s'₂, ..., s'ₙ where sᵢ encodes the first component of pairs of S x S, the s'ᵢ encoding the second component of pairs of S x S. First, the BDD of the graph of the canonical application of tins equivalence relation is built and named C(Eₙ₋₁). C(Eₙ₋₁) is built on the boolean variables s₁, s₂, ..., sₙ, s'₁, s'₂, ..., s'ₙ, in which the sᵢ encode the first component of pairs of S x S and the s'ᵢ encode the second component.

Let ϕ be a function of the type S x S having a graph C(Eₙ₋₁). From the BDD of C(Eₙ₋₁) and transition function δ is computed vector δⁿ⁻¹ in accordance with the method of the invention. The vector δⁿ⁻¹ is built by renaming the variables s into s'. Then is computed the set ∀x(δⁿ⁻¹ ⇔ δ'ⁿ⁻¹). The set Eₙ is the intersection of this latter set built on the variables s₁, s₂, ..., sₙ, s'₁, s'₂, ..., s'ₙ and set E₁. Thus, the set ∀x(Δ⁻¹(Eₙ₋₁) is built from δⁿ⁻¹ in the same manner as E₁ is constructed from Λ. Finally, the set Eₙ is equal to (∀x(Δ⁻¹(Eₙ₋₁)∧E₁).

The following second algorithm is given for the iterative step. This algorithm takes as input the BDD of Eₙ₋₁ and the list of variables (s'₁, s'₂, ..., s'ₙ) used for a copy of state variables and for the range of cross-section C(Eₙ₋₁). The returned result is the BDD of (Eₙ₋₁). Both Eₙ and Eₙ₋₁ have variable support s₁, s₂, ..., sₙ, s'₁, s'₂, ..., s'ₙ. The algorithm 2 is :

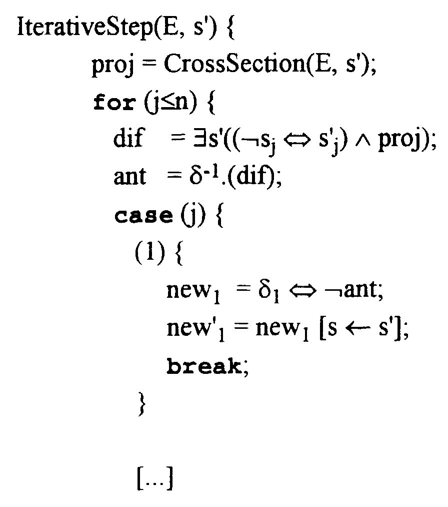

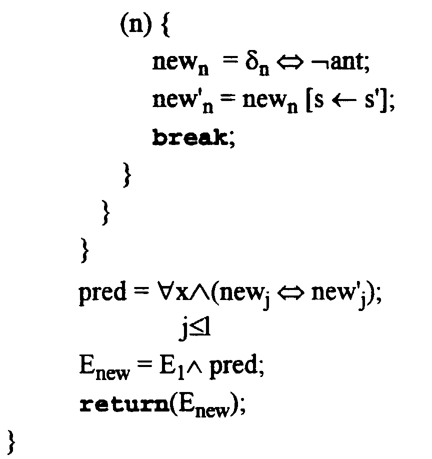

Comparison have been made between the algorithm of the present invention and the implementation of the prior art algorithm. The method of the invention enables less space complexity due the simplification of reverse image computation and generally allows better results in time. The following table shows the features of the testing models : circuit name of the ISCAS89 - benchmarks -, number of variables (successively: inputs; outputs; states), number of vertices of all BDD's, number of equivalence classes and number of steps required for computation.

| circuit name | variables | vertices | equivalence classes | steps |
|---|---|---|---|---|
| s344 | 9 ; 11 ; 15 | 164 | 18608 | 5 |
| s1488 | 8 ; 19 ; 6 | 476 | 49 | 2 |
| s298 | 3 ; 6 ; 14 | 117 | 8061 | 16 |
| s382 | 3 ; 6 ; 21 | 174 | 608448 | 93 |

The following table show the results from the method of the invention compared with the prior method. CPU times are reported in seconds on an IBM RS-6000 Workstation.

| circuit name | CPU time | | memory | |
|---|---|---|---|---|
| | invention | prior art | invention | prior art |
| s344 | 1.9 | 21.0 | 0.9 | 2.2 |
| s1488 | 1.0 | 12.7 | 0.6 | 1.7 |
| s298 | 8.5 | 286.4 | 1.6 | 7.5 |
| s382 | 480.6 | 2608.4 | 3.7 | 10.6 |

The vertices created for computation appear from the following table.

| circuit name | vertices | |
|---|---|---|
| | invention | prior art |
| s344 | 27127 | 110314 |
| s510 | 16358 | 64387 |
| s1488 | 15935 | 97622 |
| s298 | 78210 | 1372970 |
| s382 | 2600773 | >3500000 |

The method of the invention can be modified by a man skilled in the art to have a plurality of various embodiments. For example, a BDD can have several embodiments, in particular the so-called TDG (Typed Decision Graph) described for example in the book The Fusion between Hardware Design and Verification, G. Milne as publisher, North-Holland, part entitled "Original Concepts of PRAM, An Industrial Tool for Efficient Formal Verification of Combinational Circuits". Any form of BDD can be used by the present invention. Furthermore, although the ordering of all the BDD's is assumed to be : s₁ < s'₁ < s₂ < ... ... sₙ < s'ₙ, another ordering can be used and the method can be modified accordingly. Also, although the description of the above embodiment of the invention has been directed to compute the set ∀x(Δ⁻¹(Eₙ₋₁), it has been shown that the invention can be extended to any quantification of each variable of x.

Also, although the method of the invention is a solution to a problem raised by a finite state machine applied to hardware design and verification, it can be extended to be a method of verification of a sequential machine having finite states, since a finite state machine is software sequential machine. For example, the method can be used for protocol verification, control interface verification and more generally for the verification, in a technical system, of software program portions having finite states. Also, it is clear that the invention can be applied for verification of a hardware sequential machine such as a sequencer and an automated machine having finite states. The meaning of word "verification" includes that of test which is to verify whether required conditions are satisfied.

Furthermore, although the above preferred embodiment shows that the method of the present invention uses an iterative computation from Eₙ₋₁, it is obvious that the present invention can be used without iterative computation and for any quantification of each variable.

As a result, the method of the invention can be defined as a method of verification of a finite state sequential machine, comprising computing by means of a data processing machine a set Y defined from two finite sets B and S encoded on boolean variables, a function δ : B → S expressed by a vector of boolean functions and an equivalence relation A on S, the set B being encoded on variables ${\text{s = s}}_{\text{1}} {\text{, ..., s}}_{\text{n}}$ and ${\text{x = x}}_{\text{1}} {\text{, ..., x}}_{\text{k}}$ , in which x can be void, and Qxᵢ designating either ∃xᵢ or ∀xᵢ, so that:${\text{Y = {(s, s') ∈ (∃x}}_{\text{1}} {\text{, ..., ∃x}}_{\text{k}} {\text{B)}}^{\text{2}} {\text{| Qx}}_{\text{1}} {\text{, ..., Qx}}_{\text{k}} \text{[(δ(s, x), δ(s', x)) ∈ A]},}$ characterized in that the computation of set Y comprises the steps of (a) constructing in a canonical way, from the BDD of the graph of the equivalence relation A, the BDD of the graph of a total function from S x S, named cross-section ad denoted C(A), (b) constructing from the cross-section and the vector δ a new vector denoted $\text{δ* = C(A) ∘ δ}$ , and (c) computing the pairs (s, s') such that $\text{Qx1, ...Qxk .(δ*(s, x) = δ(s', x))}$ . In this definition, the sets B and S are any sets which can be different from the above sets B and S, the variables s and x are any variables which can be different form the above variables s and x, the equivalence relation A is any equivalence relation and the function δ can be another function than the transition function of a FSM. Since no iterative computation is made, the vector δ* is used in lieu of δⁿ⁻¹ in the iterative computation of the above embodiment. The equation for computation of Y is the algorithm of computation of a reverse image. Accordingly, the connection of this general definition with the method as described in the above embodiment can be made in defining the latter as a method used to compute an equivalence relation (E) of a finite state machine FSM, the equivalence relation (E) being defined as the fixpoint of a monotonic suite E₁, ..., Eₙ = E, the computation of the equivalence relation (E) being made by successively constructing the set Eₙ by use of the reverse image of Eₙ₋₁ defined in terms of said set Y.

In the above description of the preferred embodiment has been shown that the canonical cross-section used in the above step (a) can be computed from the compatible projection using the following definition : let B and C be two sets and ϕ a relation from B into C ad let ≤ be a total order on C, then the cross-section of ϕ is the partial function C(ϕ) defined as :$\text{C(ϕ): | B → C} \text{| x ↦ min({y|(x, y) ∈ ϕ}).}$

In this definition is assumed that the increasing ordering of the variables. Another ordering and definition could be used. For example, another ordering can be used in replacing in the above definition "let ≤ be a total order on C" by "let < be a total strict order on C. Also, a computation from another method than the compatible projection can be used.

From theorem 1 in the preferred embodiment can also be shown that in step (b) in the general definition of the present invention the vector δ* is built from vector δ ad graph C(A), this graph being encoded on said variable ${\text{s = s}}_{\text{1}} {\text{, ..., s}}_{\text{n}}$ for the domain and on a variable ${\text{s' = s'}}_{\text{1}} {\text{, ..., s'}}_{\text{n}}$ for the codomain, while δ* is built by using the sets ${\text{D}}_{\text{j}} {\text{= ∃s'(¬(s}}_{\text{j}} {\text{⇔s'}}_{\text{j}} \text{) ∧ C(A))}$ and performing the reverse image computation uniquely for the sets Dj. The word "uniquely" is a consequence of the present invention.

The method can be carried out by a computer program of an information support such as a magnetic tape or disk and by a verification tool.

## Claims

1. Method of verification of a finite state sequential machine (FSM) representing a technical system, said method comprising computing by means of a data processing machine a set Y defined from two finite sets B and S encoded on boolean variables, a function δ : B → S expressed by a vector of boolean functions, and an equivalence relation A on S, the set B being encoded on variables s = s₁, ..., sₙ and x = x₁, ..., xₖ, in which x can be void, and Qxᵢ designating either ∃xᵢ or ∀xᵢ, so that :${\text{Y = {(s, s') ∈ (∃x}}_{\text{1}} {\text{, ..., ∃x}}_{\text{k}} {\text{B)}}^{\text{2}} {\text{| Qx}}_{\text{1}} {\text{, ..., Qx}}_{\text{k}} \text{[(δ(s, x), δ(s',x)) ∈ A]},}$ said computation of said set Y comprising the steps of (a) constructing in a canonical way, from the BDD of the graph of the equivalence relation A, the BDD of the graph of a total function from S x S, named cross-section and denoted C(A), (b) constructing from the cross-section and the vector 6 a new vector denoted δ* = C(A) o δ, and (c) computing the pairs (s, s') such that Q x₁, ... Qxₖ .(δ*(s, x) = δ(s', x)).

2. Method according to claim 1, characterised in that it is used to compute an equivalence relation E of the finite state machine (FSM), the equivalence relation E being defined as the fixpoint of a monotonic suite E₁, ..., Eₙ = E , the computation of the equivalence relation E being made by successively constructing the set Eₙ by use of the reverse image of the set Eₙ₋₁ defined in terms of said set Y and corresponding to Δ⁻¹(Eₙ₋₁).

3. Method according to claim 1 or 2, characterised in that said step (a) is computed from the compatible projection in which is used the following definition : let B and C be two sets and ϕ a relation from B into C and let < be a total strict order on C, then the cross-section of ϕ is the partial function C(ϕ) defined as :$\text{C(ϕ): | B → C} \text{| x ↦ min({y|(x, y) ∈ ϕ}).}$

4. Method according to claim 1 or 2, characterised in that said step (a) is computed from the compatible projection in which is used the following definition : let B and C be two sets and ϕ a relation from B into C and let ≤ be a total order on C, then the cross-section of (ϕ is the partial function C((ϕ) defined as :$\text{C(ϕ): | B → C} \text{| x ↦ min({y|(x, y) ∈ ϕ})}$ and the order is selected to be a successive increasing order.

5. Method according to anyone of claims 1 to 4, characterised in that in the step (b) the vector δ* is built from the vector δ and the graph C(A), this graph being encoded on said variable s = s₁, ..., sₙ for the domain and on a variable s' = s'₁, ..., s'ₙ for the codomain, and δ* is also built by using the sets Dⱼ = ∃s'(¬(sⱼ ⇔ s'ⱼ) Λ C(A)) and performing the reverse image computation uniquely for the sets Dj.

6. Method according to anyone of claims 2 to 5, characterised in that said step (b) comprises constructing from said cross-section and said vector 6 a new vector δⁿ⁻¹ = C(Eₙ₋₁) o δ.

7. Method according to claim 6, characterised in that it further comprises a step (c) of computing the equivalent pairs of states with respect to the vector δⁿ⁻¹ to have the pairs of (∀xΔ⁻¹(Eₙ₋₁)).

## Patentansprüche

1. Verfahren zum Prüfen einer sequentiellen Finite State Machine (FSM), die ein technisches System repräsentiert, wobei das Verfahren enthält: Berechnen mit einer Datenverarbeitungsmaschine einer Menge Y, die durch zwei endliche Mengen B und S definiert ist, die über Boolschen Variablen codiert ist, einer Funktion δ: B → S, die durch einen Vektor aus Boolschen Funktionen gegeben ist, sowie einer Äquivalenzrelation A in S, wobei die Menge B über Variablen s = s₁, ..., sₙ und x = x₁, ..., xₖ codiert ist, wobei x leer sein kann und wobei Qxᵢ entweder ∃xᵢ oder ∀xᵢ bezeichnet, derart, daß:${\text{Y = {(s,s')∈(∃x}}_{\text{1}} {\text{,...,∃x}}_{\text{k}} {\text{B)}}^{\text{2}} {\text{|Qx}}_{\text{1}} {\text{,...,Qx}}_{\text{k}} \text{[(δ(s,x),δ(s',x))∈A]}}$ wobei die Berechnung der Menge Y die folgenden Schritte enthält: (a) Konstruieren des BDD des Graphen einer Gesamtfunktion von S x S, die Querschnitt genannt wird und mit C(A) bezeichnet ist, aus dem BDD des Graphen der Äquivalenzrelation A in kanonischer Weise, (b) Konstruieren eines neuen Vektors, der mit δ* = CA ° δ bezeichnet ist, aus dem Querschnitt und dem Vektor δ und (c) Berechnen der Paare (s, s'), derart, daß Qx₁, ...,Qxₖ • (δ*(s, x) = δ (s', x)).

2. Verfahren nach Anspruch 1, dadurch gekennzeichnet, daß es zum Berechnen einer Äquivalenzrelation E der Finite State Machine (FSM) verwendet wird, wobei die Äquivalenzrelation E definiert ist als Fixpunkt einer monotonen Folge E₁, ..., Eₙ = E, wobei die Berechnung der Äquivalenzrelation E durch sukzessives Konstruieren der Menge Eₙ unter Verwendung des Umkehrbildes der Menge Eₙ₋₁, das anhand der Menge Y definiert ist und Δ⁻¹(Eₙ₋₁) entspricht, erfolgt.

3. Verfahren nach Anspruch 1 oder 2, dadurch gekennzeichnet, daß der Schritt (a) aus der kompatiblen Projektion berechnet wird, in der die folgende Definition verwendet wird: Es seien B und C zwei Mengen und ϕ eine Beziehung von B in C und es sei < eine strikte Gesamtordnung in C, dann ist der Querschnitt von ϕ die Partialfunktion C((ϕ), die folgendermaßen definiert ist:$\text{C(ϕ): |B → C} \text{|x |→ min({y|x,y) ∈ϕ}}$

4. Verfahren nach Anspruch 1 oder 2, dadurch gekennzeichnet, daß der Schritt (a) aus der kompatiblen Projektion berechnet wird, in der die folgende Definition verwendet wird: Es seien B und C zwei Mengen und ϕ eine Beziehung von B nach C und es sei ≤ eine Gesamtordnung auf C, dann ist der Querschnitt ϕ die Partialfunktion C(ϕ), die definiert ist durch:$\text{C(ϕ): |B → C} \text{|x |→ min({y|x,y) ∈ϕ}}$ wobei für die Ordnung eine sukzessive ansteigende Ordnung gewählt ist.

5. Verfahren nach irgendeinem der Ansprüche 1 bis 4, dadurch gekennzeichnet, daß im Schritt (b) der Vektor δ* aus dem Vektor δ und dem Graphen C(A) aufgebaut wird, wobei dieser Graph auf der Variable s = s₁, ..., sₙ für den Bereich und auf einer Variable s' = s'₁...sₙ für den Cobereich codiert ist, und δ* auch unter Verwendung der Mengen Dj = ∃s'(¬(sⱼ ⇔ s'ⱼ) ∧ C(A)) aufgebaut ist, wobei die Berechnung des Umkehrbildes ausschließlich für die Mengen Dⱼ ausgeführt wird.

6. Verfahren nach irgendeinem der Ansprüche 2 bis 5, dadurch gekennzeichnet, daß der Schritt (b) die Konstruktion eines neuen Vektors δⁿ⁻¹ = C(Eₙ₋₁) ° δ aus dem Querschnitt und dem Vektor δ enthält.

7. Verfahren nach Anspruch 6, dadurch gekennzeichnet, daß es ferner einen Schritt (c) des Berechnens äquivalenter Paare von Zuständen in bezug auf den Vektor δⁿ⁻¹ enthält, um die Paare (∀xΔ⁻¹(Eₙ₋₁)) zu erhalten.

## Revendications

1. Procédé de vérification d'une machine séquentielle à états finis (FSM) représentant un système technique, ledit procédé comprenant le calcul, au moyen d'une machine de traitement de données, d'un ensemble Y défini à partir de deux ensembles finis B et S codés sur des variables booléennes, d'une fonction δ : B → S exprimée par un vecteur de fonctions booléennes, et d'une relation d'équivalence de A sur S, l'ensemble B étant codé sur les variables s = s₁, ..., sₙ et x = x₁, ... xₖ, où x peut être nulle, et Qxᵢ désignant soit ∃xᵢ soit ∀xᵢ, de sorte que:${\text{Y = {(s,s') ∈ (∃x}}_{\text{1}} {\text{, ..., ∃x}}_{\text{k}} {\text{B)}}^{\text{2}} {\text{| Qx}}_{\text{1}} {\text{, ..., Qx}}_{\text{k}} \text{[(δ(s,x), δ(s', x)) ∈ A]},}$ ledit calcul dudit ensemble Y comprenant les étapes de (a) construction d'une manière canonique, à partir du BDD du graphe de la relation d'équivalence A, du BDD du graphe d'une fonction totale issue de S x S, appelée section et notée C(A), (b) construction à partir de la section et du vecteur δ d'un nouveau vecteur noté δ* = C(A)∘δ, et (c) calcul des paires (s, s') de sorte que Qx₁, ..., Qxₖ·(δ*(S, x) = δ(s', x)).

2. Procédé selon la revendication 1, caractérisé en ce qu'il est utilisé pour calculer une relation d'équivalence E de la machine à états finis (FSM), la relation d'équivalence E étant définie comme le point fixe d'une suite monotone E₁, ..., Eₙ = E, le calcul de la relation d'équivalence E étant effectué par construction successive de l'ensemble Eₙ en utilisant l'image inverse de l'ensemble Eₙ₋₁ définie en fonction dudit ensemble Y et correspondant à Δ⁻¹(Eₙ₋₁).

3. Procédé selon la revendication 1 ou 2, caractérisé en ce que ladite étape (a) est calculée à partir de la projection compatible dans laquelle est utilisée la définition suivante: soit B et C deux ensembles et ϕ une relation de B dans C et soit < un ordre total strict sur C, alors la section de ϕ est la fonction partielle C(ϕ) définie par:$\text{C(ϕ): | B → C} \text{| x ↦ min({y|(x,y) ∈ ϕ}).}$

4. Procédé selon la revendication 1 ou 2, caractérisé en ce que ladite étape (a) est calculée à partir de la projection compatible dans laquelle est utilisée la définition suivante: soit B et C deux ensembles et ϕ une relation de B dans C et soit ≤ un ordre total sur C, alors la section de ϕ est la fonction partielle C(ϕ) définie par:$\text{C(ϕ): | B → C} \text{| x ↦ min({y|(x,y) ∈ ϕ})}$ et l'ordre est choisi de façon à être un ordre successif croissant.

5. Procédé selon l'une quelconque des revendications 1 à 4, caractérisé en ce que dans l'étape (b), le vecteur δ* est construit à partir du vecteur δ et du graphe C(A), ce graphe étant codé sur ladite variable s = s₁, ..., sₙ pour le domaine et sur une variable s' = s'₁, ..., s'ₙ pour le codomaine, et δ* est également construit en utilisant les ensembles Dⱼ = ∃s'(¬(sⱼ ⇔ s'ⱼ) ∧ C(A)) et en réalisant le calcul de l'image inverse uniquement pour les ensembles Dⱼ.

6. Procédé selon l'une quelconque des revendications 2 à 5, caractérisé en ce que ladite étape (b) comprend la construction, à partir de ladite section et dudit vecteur δ, d'un nouveau vecteur δⁿ⁻¹ = C(Eₙ₋₁) ∘ δ.

7. Procédé selon la revendication 6, caractérisé en ce qu'il comprend en outre une étape (c) de calcul des paires d'états équivalentes par rapport au vecteur δⁿ⁻¹ pour obtenir les paires de (∀xΔ⁻¹(Eₙ₋₁)).
